# EUROPEAN PATENT SPECIFICATION

(11) **EP 3 758 046 B1**
(45) Date of publication and mention of the grant of the patent: **15.04.2026**
(21) Application number: 19305873.2
(22) Date of filing: 28.06.2019
(51) Int. Cl.: H01L 21/20

(54) **METHOD FOR COMBINING SILICON MATERIAL AND III-V MATERIAL, AND ASSOCIATED DEVICE**
VERFAHREN ZUM KOMBINIEREN VON SILICIUMMATERIAL UND III-V-MATERIAL UND ZUGEHÖRIGE VORRICHTUNG
PROCÉDÉ DE COMBINAISON DE MATÉRIAU DE SILICIUM ET DE MATÉRIAU III-V ET DISPOSITIF ASSOCIÉ

(43) Date of publication of application: 30.12.2020
(73) Proprietor: Nokia Solutions and Networks Oy, 02610 Espoo (FI)
(72) Inventor: DECOBERT, Jean, 91620 Nozay (FR); BESANCON, Claire, 75014 Paris (FR)
(74) Representative: MERH-IP Matias Erny Reichl Hoffmann Patentanwälte PartG mbB

(56) References cited:
- EP-A1- 3 376 525
- EP-A1- 3 477 717
- US-A- 4 910 164
- US-A1- 2007 170 417
- US-A1- 2017 213 938
- KIM SANG-HYEON ET AL: "Heterogeneous Integration Toward a Monolithic 3-D Chip Enabled by III-V and Ge Materials", IEEE JOURNAL OF THE ELECTRON DEVICES SOCIETY, vol. 6, 6 February 2018 (2018-02-06), pages 579 - 587, XP011683220, [retrieved on 20180507], DOI: 10.1109/JEDS.2018.2802840

## Description

### TECHNICAL FIELD

The present invention relates to optical components, in particular to photonic devices.

### BACKGROUND

Telecommunication architectures and infrastructures are relying more and more on optical communication. Reliable and cost efficient multi gigabit transmissions over optical medium are needed in a broad variety of scenario, such as in datacenters, or for end-user's data delivery. Optical components are thus key components in optical communications to achieve the desired and increasing data rates.

Silicon-On-Insulator (SOI) waveguide circuits have been in used in the field of optical components. SOI components have a large refractive index which is advantageous for integration and compacity of optical devices. Complementary Metal-Oxide-Semiconductor (CMOS) technology offer the maturity and cost efficiency for advanced photonics components. Combination of III-V materials (combining elements from group III and group V of the periodic table of elements) on top of silicon waveguide circuits allows to design complex integrated circuits by compensating the low efficiency in light emission and amplification of the silicon material. Such combination of different family of materials is achieved with heterogenous integration through wafer bonding.

An example of heterogenous integration is an optical transceiver based on Distributed Feedback (DFB) lasers with modulation and (de)multiplexing. Such components are used for example for Coarse Wavelength Division Multiplexing (CWDM) transmissions. Compared to Wavelength Division Multiplexing (WDM) or Dense Wavelength Division Multiplexing (DWDM), CWDM resources allocation requires a large channel spacing, usually around 20 nm, in order to be more resilient to variations in temperature and wavelength shifts. Typical CWDM system operates with eight channels/wavelengths in the 1.55 µm region. Laser emissions occur at predefined wavelengths spaced 20 nm apart between 1470 nm and 1610 nm. CWDM lasing components need then to operate on a wavelength distribution of 140 nm which is one of the highest bandgap extensions of active devices.

DFB laser modules can be hybrid or monolithically integrated. Hybrid laser modules are based on discrete components. Monolithically integrated laser modules simplify alignment and packaging process which is more cost effective. However efficient monolithically integrated DFB are harder to design because of the large required wavelength distribution. An example of a design difficulty is that large lasing wavelength detuning from the gain peak results in Fabry-Pérot mode lasing is limiting the number of channels that can be integrated on the same substrate.

It is then needed to improve optical components with large bandgap regions.

State of the art is known from EP 3 477 717 A1, US 2017/0213938 A1, US 4,910,164 and JOURNAL OF THE ELECTRON DEVICES SOCIETY, published 6 February 2018, Digital Object Identifier DOI: 10.1109/ JEDS.2018.2802840.

### SUMMARY

Example embodiments of the invention aims to remedy all or some of the disadvantages of the above identified prior art.

The embodiments and features, if any, described in this specification that do not fall under the scope of the independent claims are to be interpreted as examples useful for understanding various embodiments of the invention.

It is particularly proposed to combine III-V materials with Silicon material.

A first example embodiment relates to a method for combining silicon "Si" material and III-V material according to claim 1.

Another example embodiment relates to a device having combined silicon "Si" material and III-V material according to claim 13.

### BRIEF DESCRIPTION OF THE DRAWINGS

Some example embodiments are now described, by way of example only, and with reference to the accompanying drawings in which:
- FIG. 1a, FIG. 1b, FIG. 1c, are schematic block diagrams depicting steps of a selective area growth by Metalorganic Vapor Epitaxy process,
- FIG. 2a, FIG. 2b, FIG. 2c, FIG. 2d are schematic block diagrams of steps to combine III-V materials and Silicon materials according to some embodiments
- FIG. 3a, FIG. 3b, FIG.3c are schematic block diagram and images of an assembly of III-V materials and Silicon materials,
- FIG. 4a, FIG. 4b, FIG.4c are schematic block diagram and images of an assembly of III-V materials and Silicon materials according to some embodiments,
- FIG. 5 is a diagram of wavelength emissions according to some embodiments,
- FIG. 6 is a schematic block diagram of a photonic device according to some embodiments.

The same reference number represents the same element to the same type of element on all drawings, unless stated otherwise.

### DETAILLED DESCRIPTION

The figures and the following description illustrate specific exemplary embodiments of the invention. It will thus be appreciated that those skilled in the art will be able to devise various arrangements that, although not explicitly described or shown herein, embody the principles of the invention and are included within the scope of the claims. Furthermore, any examples described herein are intended to aid in understanding the principles of the invention, and are to be construed as being without limitation to such specifically recited examples and conditions. As a result, the invention is not limited to the specific embodiments or examples described below, but by the claims.

In the following description, well-known functions or constructions by the man skilled in the art are not described in detail since they would obscure the invention in unnecessary detail.

In the following description of the figures, schematic representations are non-limiting and serve only for the understanding of the invention.

In the following description, the compounds may be written with their respective presence in parenthesis (compound A(d)B(e)C(f) with 'd' mole fraction of 'A', 'e' mole fraction of B and 'f' mole fraction of C) or in indices (same compound A_{d}BₑC_{f} with 'd' mole fraction of 'A', 'e' mole fraction of B and 'f' mole fraction of C).

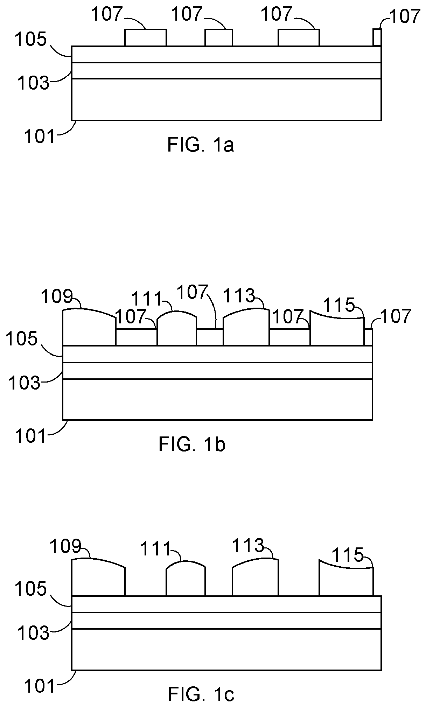

Referring to figures 1a, 1b, 1c, schematic block diagrams of a process of Selective Area Growth (SAG) by Metalorganic Vapor Phase Epitaxy (MOVPE, or also equivalently organometallic vapor-phase epitaxy OMVPE or metalorganic chemical vapor deposition MOCVD) are depicted.

For realizing monolithically integrated components enabled to lase at different wavelengths with a large distribution, a selective growth of quantum Well on the silicon substrate may be used.

Figure 1a depicts a silicon wafer or a Silicon-On-Insulator (SOI) wafer 101 prepared with an oxidation step forming a layer 103. A III-V material wafer 105, such as Indium Phosphide (InP) is bonded on the oxidized silicon layer 103 (for example made of silicon dioxide SiO₂) through molecular bonding for example. Once an assembly is formed with the III-V material wafer 105 and silicon wafer 101, the III-V material layer 105 may be thinned by etching to transform it into an III-V material buffer, such as an InP buffer, in the range 10 nm to 5.10³ nm. A dielectric mask 107, for example silicon dioxide SiO₂ is deposited on the InP 105 layer. The dielectric mask 107 and the III-V material are representative of the required elements to be present on the monolithically integrated components.

Figure 1b depicts the assembly of figure 1a on which a growth step has been achieved. In an example, Multiple Quantum Wells (MQW) 109, 111, 113, 115 are grown by a MOVPE method on the InP layer 105, in-between the dielectric mask 107.

Figure 1c depicts the assembly of figure 1b after removal of the dielectric mask 107. Such removal could be achieved through a chemical process or plasma etching for example. The resulting MQW are enabled to form the basis of a light emitting device. In an example the MQW 109 forms a laser, the MQW 111 forms a Multi-Mode Interference (MMI) and the MQW 113 or 115 form an Electro-Absorption Modulator (EAM).

There exist some drawbacks in the process of selective area growth with MOVPE. High temperatures above 500°C are required to the growth of III-V materials. The interfaces between the different materials may suffer from these temperatures, in particular when anomalies are present in the materials or at their interfaces. For example, molecular bonding using hydrophilic direct bonding introduces oxidation of layers with hydrogen production at high temperatures. Such phenomenon can damage the interface layer, lowers the efficiency of the components and renders the process more difficult to achieve.

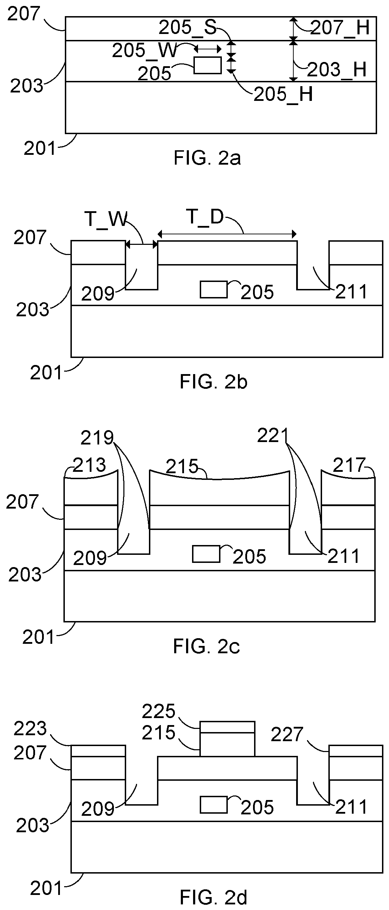

Referring to figures 2a, 2b, 2c, 2d, schematic block diagrams of steps to combine III-V materials and Silicon materials according to some embodiments are depicted.

The respective terms "wafer" and "layer", for example in association with a material, such as silicon, silicon-on-insulator, III-V material, are used equivalently hereinafter.

Figure 2a depicts a first step in the process of combining Silicon materials and III-V materials according to an embodiment.

A wafer of Silicon substrate 201 is bonded with an interface layer 203. In examples the interface layer 203 is a SiO₂ layer. In examples, SiO₂ layer 203 may be around 5 nm to 2 µm of height 203_H.

A Silicon waveguide 205 is comprised into the interface layer 203. In an example, the Si waveguide 205 is buried in the interface layer 203, has a height 205_H around 300 nm, and is distant of around 80 nm (205_S) from the top surface of a SiO₂ layer 203. Said Si waveguide 205 has a width 205_W of around 700 nm.

A III-V material layer 207 is bonded to the top surface of the interface layer 203. In an example the III-V material layer is an InP layer. The bonding may be realized through hydrophilic molecular bonding technique in an example. The III-V material layer 207 may be bonded with the appropriate thickness or may be further etched to obtain a thin layer. In an example an InP layer 207 has an height 207_H in the range of 50 nm to 1 µm.

In other examples, different configuration of the arrangement of the Silicon substrate 201, the interface layer 203, and the III-V material layer 207 are possible.

Figure 2b depicts a second step in the process of combining Silicon materials and III-V materials according to an embodiment.

In the stacked layers of Si substrate 201, interface layer 203, Si waveguide 205 and III-V material layer 207, a first recess or trench 209 and a second recess or trench 211 are formed across said layers. The first trench 209 defines a substantially vertical recess through the III-V material layer 207 and partly through the interface layer 203. The width T_W of a trench is in the magnitude of several micrometers, for example in the range around 1 µm to around 50 µm. In an example, the width T_W of the first recess or trench 209 and the second recess or trench 211 is around 10 µm. In another example the first trench 209 and the second trench 211 have different width in the order of several micrometers. The spacing T_D between the first recess 209 and the second recess 211 is between approximately 1 µm to approximately 100 µm. In an example the spacing T_D is of around 100 µm. In an example, several trenches or recesses are formed in the assembly from figure 2a, the trenches having a spacing periodicity of around 100 µm. In another example, the spacing between two trenches is lower than 100 µm, for example inferior to approximately 40 µm. Such a spacing between two recess is advantageous for growing MQW through selective area growth in an example.

In an example, the first recess or trench 209 and the second recess or trench 211 are symmetrical according to the Si waveguide 205. Advantageously the geometry of the location of the recesses allows an increase in the cooperation between the Si waveguide 205 and the MQW.

In an embodiment, the number of recesses depends on the required number of multiple quantum wells structures to be coupled with the Silicon materials.

In an embodiment, the depth of a recess is sufficient so that the bottom of said recess comprises the interface layer 203. In an example, a portion of the interface layer 203 is visible through the recess formed in the III-V material layer. In an example the depth of the recess is comprised between the height 207_H of the III-V material layer 207 and the height 207_H of said III-V material layer 207 plus the height 203_H of the interface layer 203. In an example, the recess extends substantially vertically through the III-V material layer 207 sand through a portion of the interface layer 203.

Figure 2c depicts another step in the process of combining Silicon materials and III-V materials according to an embodiment.

The stacked assembly of the Si substrate 201, the SiO2 layer 203, the Si waveguide 205, the InP layer 207, the first trench 209 and the second trench 211 are exposed to a MOVPE process. Multiple Quantum Wells 213, 215, 217 are then grown on the InP layer 207. The growth of the MQWs occur on the surface of said InP bonding layer and each MQW 213, 215, 217 is delimited by the respective first trench or recess 209 and second trench or recess 211.

Advantageously, the dielectric SiO₂ layer 203 acts as a selective mask during the MOVPE process thanks to the presence of the first trench or recess 209 and the second trench or recess 211. The thickness of the material deposited in the vicinity of said recesses is related to their respective width T_W. In case of MQW growth, the width T_W of a recess is linked to the photoluminescence wavelength emission of said MQW.

In an embodiment the MQW are grown with a Selective Area Growth method.

Figure 2d depicts other steps in the process of combining Silicon materials and III-V materials for obtaining active waveguide structure according to an embodiment.

Optional steps may be performed on the assembly obtained from figure 2c in order to design different kind of device. In an example the MQW 213 and 217 are removed and MQW 215 is planarized. MQW 213 and 217 are replaced by InP buffers 223 and 227. An additional InP layer 225 is bonded on top of the MQW 215. It is obtained then an active waveguide structure such as laser or semiconductor optical amplifier (SOA) or a modulator for CWDM transmissions.

Multiple quantum well structures have active region, which restricts electron and hole motion in a direction normal to the well, designed for efficient and coherent photon emission.

Referring again to Figure 2c, the required growth temperature by MOVPE is above 500°C to obtain high quality material. Such high temperatures increase the hydrogen desorption from the interface layer. Advantageously, the assembly of layers as depicted in FIG. 2c facilitates gas diffusion at the interfaces 219 between the interface layer 203 and the III-V material layer 203. Thanks to the formed first trench or recess 209, during the heating process, a degassing of the hydrogen occurs. A similar degassing phenomenon occur at the interface 221 thanks to the second trench or recess 211.

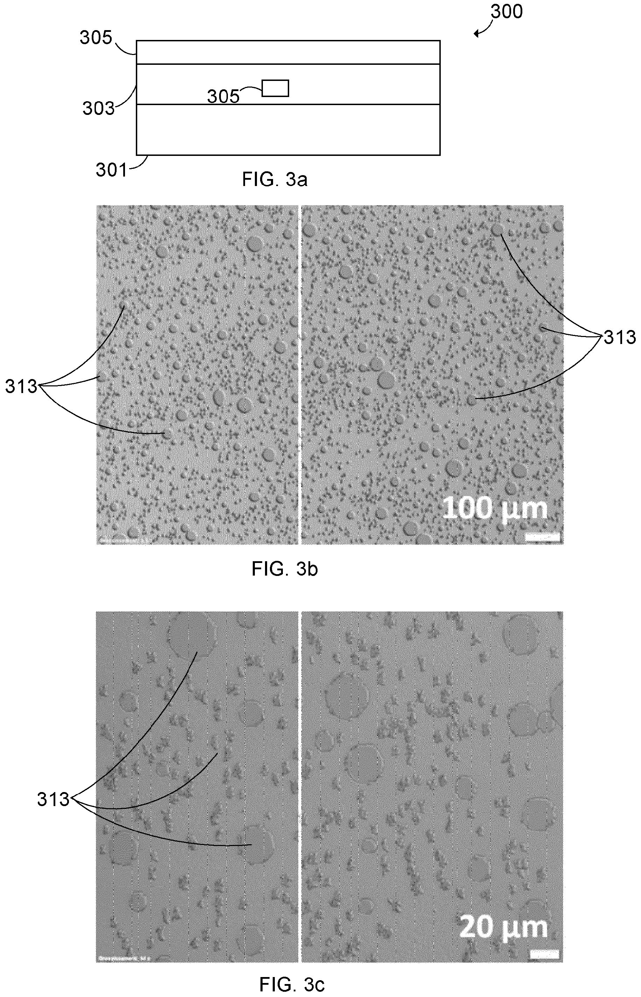

Referring to figures 3a, 3b, 3c, a schematic block diagram and images of an assembly of III-V materials and Silicon materials are depicted.

The figure 3a schematizes a stacked assembly 300 of a Si substrate 301, with an oxidation layer of SiO₂ layer 303, with a InP layer 305 bonded on top of said SiO₂ layer 303, through molecular bonding for example.

The stacked assembly 300 is annealed in the same conditions as a MOVPE process. In an example the required growth temperature by MOVPE is above 650°C. Such high temperatures have an impact on the materials of the stacked assembly 300, and in particular at the interfaces between different type of material.

The figure 3b is a microscopy image (100 µm scale) of a bonded seed or combined material layers of the stacked assembly 300 after annealing. Anomalies 313 originate from the instability of the interface layer at high temperature. During growth at high temperature, gas is generated at the bonding interface between the interface layer 303 and the III-V material layer 305. The gas pierces the III-V material layer 305 resulting in the anomalies 313. The figure 3c is a microscopy image (20 µm scale) of the same bonded seed. The anomalies or imperfections 313 have a relatively high density within the material.

The anomalies 313 (due to degassing of hydrogen bubbles in an example) are imperfections or anomalies in the material that decrease the efficiency of the interaction between the different materials. Furthermore, since the density of these anomalies may vary depending on the materials and/or the annealing, more tolerance is induced with regards to the operating points of the stacked assembly 300.

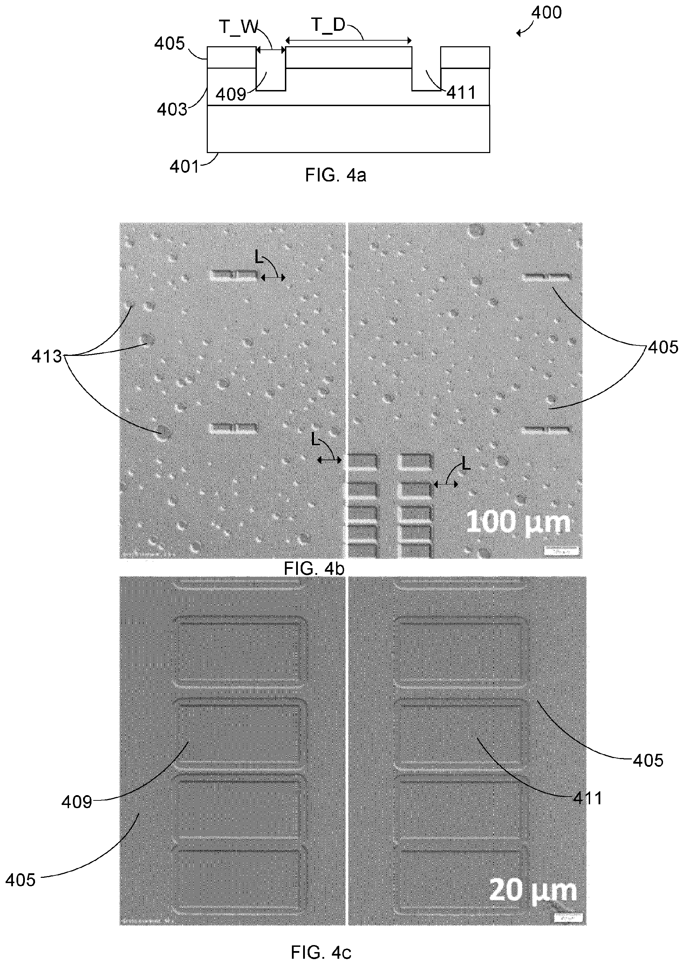

Referring to figures 4a, 4b, 4c, a schematic block diagram and images of an assembly of III-V materials and Silicon materials according to some embodiments are depicted.

The figure 4a schematizes a stacked assembly 400 comprising a Si substrate 401, an interface layer 403, a III-V material layer 405, and a first recess 409 extending from the top surface of the III-V material layer 405 down to a portion of the interface layer 403, and a second recess 411 extending from the top surface of the III-V material layer 405 down to a portion of the interface layer 403. In an example, the first trench or recess 409 and the second trench or recess 411 are separated by approximatively 100 µm.

In an example the stacked assembly 400 is obtained according to the steps of the process depict in figures 2a, 2b.

The stacked assembly 400 is annealed in the same conditions as a MOVPE process, at more than 600°C.

The figure 4b is a microcopy image (100 µm scale) of a bonded seed of the stacked assembly 400 after annealing.

The anomalies 413, typically small pockets formed by degassing, have a lower density compared to the anomalies 313 from the stacked assembly 300.

Around the area of the trenches 409, 411, with the interface layer 403, the SiO₂ interface layer in an example, at the bottom of the recess of said trenches, the InP layer 405 does not exhibit anomalies 413. These areas free from anomalies are extending of a distance L, of approximately 50 µm from the boundaries of the trenches.

The figure 4c is a microscopy image (20 µm scale) of the stacked assembly 400. The InP layer 405 does not exhibit imperfections or anomalies due to the delamination of the InP layer 405 in the surroundings of the trenches.

Advantageously, the addition of trenches allows to avoid generation of anomalies, such as holes or pockets created by degassing, during the heating process of the stacked assembly 400.

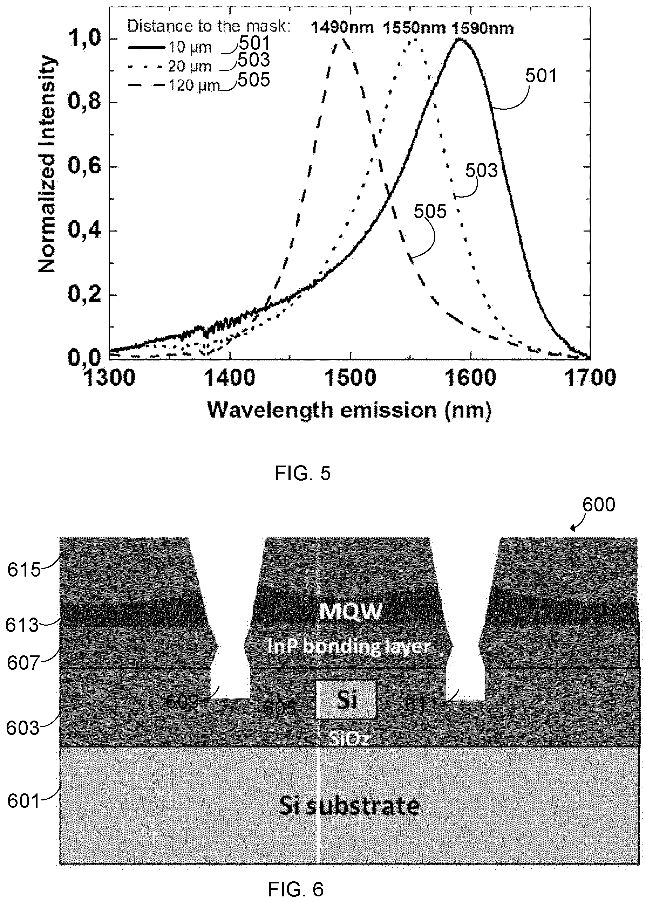

Referring to FIG. 5 a diagram of wavelength emissions according to some embodiments is depicted.

The figure 5 comprises plots 501, 503, 505 of wavelength emissions obtained from a light emitting device comprising stacked assembly with MQW according to some embodiments. In this example, the stacked assembly is similar as the assembly 200 from figures 2a, 2b, 2c, 2d, each stacked assembly comprising a single trench that forms a recess between the III-V material layer and the interface layer. The single trench acts as a selective mask for the growth of MQW and as a degassing means and controls the lateral growth of said growth of MQW. The plots 501... 505 correspond to wavelength emissions obtained at different point or location on the MQW.

The x-axis corresponds to wavelengths and has a nm scale. The y-axis of the plots 501, 503, 505 corresponds to normalized intensity of the wavelength emissions.

**Table 1: wavelength emissions for different stacked assemblies of Si materials combined with III-V materials**

| Plot reference number | Distance to the mask (µm) | Wavelength of gain maximum (nm) |
|---|---|---|
| 501 | 10 | 1590 |
| 503 | 20 | 1550 |
| | 30 | 1530 |
| | 40 | 1515 |
| | 50 | 1507 |
| | 60 | 1503 |
| | 70 | 1500 |
| | 90 | 1495 |
| 505 | 120 | 1490 |

It can be observed that there exists a relationship between the peak wavelength emission from the plots 501... 505 with their respective distance to the mask. A wavelength shift of around 100 nm occurs between the peak wavelength emission of the wavelength emitted by the MQW from a distance to the recess or mask of 10 µm and the wavelength emitted by said MQW from a distance to the recess or mask of 120 µm.

Advantageously, according to some embodiments, the trench or recess acts as a mask that enables to master the growth of MQW, allowing to obtain a span of wavelengths emission by said MQW depending on the distance to the recess. Design of various and efficient light emitting device based on stacked assembly of Si materials combined with III-V materials is then facilitated

Furthermore, a trench allows to avoid creation of anomalies, thanks to a degassing effect, within the materials during heating process, for growing MQW in an example. It is then possible to obtain stacked assemblies of combined Si materials and III-V materials that are more efficient.

According to some embodiments, a trench allows also part of the Si materials, such as the SiO2 layer/substrate to act as a "Selective Area Growth" mask. Therefore, the trench or recess acts as a mask during the growth of MQW. It is then possible to grow MQW with precision and reliability. Furthermore, the process to grow MQW is simplified since a trench or recess is easily formed in the stacked assembly of materials.

Referring to FIG. 6, a schematic block diagram of a photonic device according to some embodiments is depicted.

In an embodiment, a stacked assembly is formed by bonding a III-V material layer 607 on an interface layer 603, which is bonded on a Si substrate 601. The interface layer 603 comprises a waveguide 605. A recess 609 is formed in the III-V material layer 607 and in the interface layer 603. Another recess 611 may also be formed in the stacked assembly.

An epitaxy growth of Multiple Quantum Well 613 is operated on the stacked assembly. Another III-V material layer 615 is bonded on the Multiple Quantum Well 613. The stacked assembly 600 forms a photonic device.

The recess 609 allows to control the growth of the MQW. Thanks to the recess 609, the interface layer 603 and the III-material layer 607 act as a lateral barrier so that the MQW is growing only substantially vertically, and not within the recess 609. According to some embodiments, a trench or recess allows also to avoid lateral overgrowth during the process of MQW growth. Advantageously a thick planar selective area growth is achievable.

According to some embodiments, it is possible to obtain monolithically integrated device for light emission based on an efficient layering of Si material and III-V materials, on which MQW are grown. Such monolithically integrated device is particularly adapted for CWDM transmission that require large wavelength distribution.

## Claims

1. A method for combining silicon "Si" material and III-V material comprising the following steps:
- layering a Si substrate (201, 401) with an interface layer (203, 403),
- layering a III-V material layer (207, 405) on the interface layer (203, 403),
- forming a first recess (209, 211) extending in the III-V material layer (207, 405) and in the interface layer (203, 403), wherein the interface layer (203, 403) is a dielectric layer (203, 403), and
wherein the first recess (209, 211) is configured for suppressing generation of an anomaly (413) in the III-V material layer (207, 405) during a step of heating the III-V material layer (207, 405), the anomaly (413) being a hole.

2. A method for combining silicon Si material and III-V material according to claim 1, wherein the step of layering the III-V material layer (207, 405) on the interface layer (203, 403) is a step of bonding the III-V material layer (207, 405) on the interface layer (203, 403) with molecular bonding.

3. A method for combining silicon Si material and III-V material according to claim 1 or claim 2, further comprising a step of heating of the III-V material layer (207, 405) on the interface layer (203, 403).

4. A method for combining silicon Si material and III-V material according to claim 2, wherein the step of bonding the III-V material layer (207, 405) on the dielectric layer (203, 403) is a step of hydrophilic molecular bonding, and further comprising a step of heating of the III-V material layer (207, 405) on said dielectric layer (203, 403), and wherein the first recess (209, 211) is configured for degassing hydrogen.

5. A method for combining silicon Si material and III-V material according to any of the claims 1 to 4, wherein the first recess has a width (T_W) on the III-V material layer (207, 405) in the from range 1 µm to 50 µm, preferably 10 µm.

6. A method for combining silicon Si material and III-V material according to any of the claims 1 to 5, further comprising a step of forming a second recess (211) extending in the III-V material layer (207, 405) and the interface layer (203, 403), wherein the distance (T_D) on the III-V material layer (207, 405) between the first recess (209) and the second recess (211) is in the range between 1 µm to 100 µm.

7. A method for combining silicon Si material and III-V material according to any of the claims 1 to 6, wherein the III-V material layer (207, 405) is an Indium Phosphide layer (207, 405) .

8. A method for combining silicon Si material and III-V material according to any of the claims 1 to 7, further comprising a step of
- growing a Multiple Quantum Well on the III-V material layer (207, 405),
- wherein the first recess (209, 211) is configured for suppressing the anomaly (413) in the III-V material layer (207, 405) during the step of growing the Multiple Quantum Well,
- wherein the first recess (209, 211) is configured for controlling the growth of the Multiple Quantum Well on the III-V material layer (207, 405).

9. A method for combining silicon Si material and III-V material according to claim 8, wherein the step of growing the Multiple Quantum Well on the III-V material layer (207, 405) is a step of Metalorganic Vapor Phase Epitaxy growth of the Multiple Quantum Well.

10. A method for combining silicon Si material and III-V material according to claim 8 or claim 9, wherein the first recess (209, 211) is configured for controlling the growth of the Multiple Quantum Well on the III-V material layer (207, 405) by acting as a growth mask and by avoiding lateral overgrowth of Multiple Quantum Well.

11. A method for combining silicon Si material and III-V material according to claim 8 or claim 9, wherein the first recess (209, 211) is configured for controlling the growth of the Multiple Quantum Well on the III-V material layer (207, 405) by acting as a selective area growth mask.

12. A method for combining silicon Si material and III-V material according to any of the claims 8 to claim 11, wherein the step of bonding the III-V material layer (207, 405) on the dielectric layer (203, 403) is a step of hydrophilic molecular bonding, and wherein the first recess (209, 211) is configured for degassing hydrogen during the step of growing the Multiple Quantum Well on the III-V material layer (207, 405).

13. A device having combined silicon "Si" material and III-V material comprising:
- a Si substrate (201, 401),
- an interface layer (203, 403) on the Si substrate (201, 401),
- a III-V material layer (207, 405) on the interface layer (203, 403),
- a first recess (209, 211) extending in the III-V material layer (207, 405) and in the interface layer (203, 403),
- said first recess (209, 211) being configured for suppressing generation of an anomaly (413) during heating of the III-V material layer (207, 405), wherein the interface layer (203, 403) is a dielectric layer (203, 403), and wherein the anomaly (413) is a hole.

14. A device having combined silicon "Si" material and III-V material according to claim 13, wherein the III-V material layer (207, 405) is an InP layer.

15. A device having combined silicon "Si" material and III-V material according to claim 13 or claim 14, further comprising:
- a waveguide (205) in the interface layer (203), and
- a Multiple Quantum Well on the interface layer (203, 403), said Multiple Quantum Well being configured to be coupled with the waveguide (205),
- said first recess (209, 211) extending in the Multiple Quantum Well,
- said first recess (209, 211) being configured for controlling the growth of the Multiple Quantum Well on the III-V material layer (207, 405).

## Patentansprüche

1. Verfahren zum Kombinieren von Silicium-"Si"-Material und III-V-Material, das die folgenden Schritte umfasst:
- Schichten eines Si-Substrats (201, 401) mit einer Grenzflächenschicht (203, 403),
- Schichten einer III-V-Materialschicht (207, 405) auf der Grenzflächenschicht (203, 403),
- Bilden einer ersten Vertiefung (209, 211), die sich in der III-V-Materialschicht (207, 405) und in der Grenzflächenschicht (203, 403) erstreckt, wobei die Grenzflächenschicht (203, 403) eine dielektrische Schicht (203, 403) ist, und
wobei die erste Vertiefung (209, 211) dazu ausgestaltet ist, eine Erzeugung einer Anomalie (413) in der III-V-Materialschicht (207, 405) während eines Schritts des Erhitzens der III-V-Materialschicht (207, 405) zu unterdrücken, wobei die Anomalie (413) ein Loch ist.

2. Verfahren zum Kombinieren von Silicium-Si-Material und III-V-Material nach Anspruch 1, wobei der Schritt des Schichtens der III-V-Materialschicht (207, 405) auf der Grenzflächenschicht (203, 403) ein Schritt des Bondens der III-V-Materialschicht (207, 405) auf der Grenzflächenschicht (203, 403) mittels molekularen Bondens ist.

3. Verfahren zum Kombinieren von Silicium-Si-Material und III-V-Material nach Anspruch 1 oder Anspruch 2, ferner umfassend einen Schritt des Erhitzens der III-V-Materialschicht (207, 405) auf der Grenzflächenschicht (203, 403).

4. Verfahren zum Kombinieren von Silicium-Si-Material und III-V-Material nach Anspruch 2, wobei der Schritt des Bondens der III-V-Materialschicht (207, 405) auf der dielektrischen Schicht (203, 403) ein Schritt des hydrophilen molekularen Bondens ist, und ferner umfassend einen Schritt des Erhitzens der III-V-Materialschicht (207, 405) auf der dielektrischen Schicht (203, 403), und wobei die erste Vertiefung (209, 211) zum Entgasen von Wasserstoff ausgestaltet ist.

5. Verfahren zum Kombinieren von Silicium-Si-Material und III-V-Material nach einem der Ansprüche 1 bis 4, wobei die erste Vertiefung eine Breite (T_W) auf der III-V-Materialschicht (207, 405) im Bereich von 1 µm bis 50 µm, vorzugsweise gleich 10 µm, aufweist.

6. Verfahren zum Kombinieren von Silicium-Si-Material und III-V-Material nach einem der Ansprüche 1 bis 5, ferner umfassend einen Schritt des Bildens einer zweiten Vertiefung (211), die sich in der III-V-Materialschicht (207, 405) und der Grenzflächenschicht (203, 403) erstreckt, wobei der Abstand (T_D) auf der III-V-Materialschicht (207, 405) zwischen der ersten Vertiefung (209) und der zweiten Vertiefung (211) im Bereich zwischen 1 µm bis 100 µm liegt.

7. Verfahren zum Kombinieren von Silicium-Si-Material und III-V-Material nach einem der Ansprüche 1 bis 6, wobei die III-V-Materialschicht (207, 405) eine Indiumphosphid-Schicht (207, 405) ist.

8. Verfahren zum Kombinieren von Silicium-Si-Material und III-V-Material nach einem der Ansprüche 1 bis 7, ferner umfassend einen Schritt des
- Aufwachsens eines Mehrfach-Quantentopfs (Multiple Quantum Well) auf der III-V-Materialschicht (207, 405),
- wobei die erste Vertiefung (209, 211) zum Unterdrücken der Anomalie (413) in der III-V-Materialschicht (207, 405) während des Schritts des Aufwachsens des Mehrfach-Quantentopfs ausgestaltet ist,
- wobei die erste Vertiefung (209, 211) zum Steuern des Aufwachsens des Mehrfach-Quantentopfs auf der III-V-Materialschicht (207, 405) ausgestaltet ist.

9. Verfahren zum Kombinieren von Silicium-Si-Material und III-V-Material nach Anspruch 8, wobei der Schritt des Aufwachsens des Mehrfach-Quantentopfs auf der III-V-Materialschicht (207, 405) ein Schritt des metallorganischen Gasphasenepitaxie-Aufwachsens des Mehrfach-Quantentopfs ist.

10. Verfahren zum Kombinieren von Silicium-Si-Material und III-V-Material nach Anspruch 8 oder Anspruch 9, wobei die erste Vertiefung (209, 211) zum Steuern des Aufwachsens des Mehrfach-Quantentopfs auf der III-V-Materialschicht (207, 405) durch Wirken als eine Aufwachsmaske und durch Vermeiden seitlichen Überwachstums des Mehrfach-Quantentopfs ausgestaltet ist.

11. Verfahren zum Kombinieren von Silicium-Si-Material und III-V-Material nach Anspruch 8 oder Anspruch 9, wobei die erste Vertiefung (209, 211) zum Steuern des Aufwachsens des Mehrfach-Quantentopfs auf der III-V-Materialschicht (207, 405) durch Wirken als eine Aufwachsmaske mit selektiver Fläche ausgestaltet ist.

12. Verfahren zum Kombinieren von Silicium-Si-Material und III-V-Material nach einem von Anspruch 8 bis Anspruch 11, wobei der Schritt des Bondens der III-V-Materialschicht (207, 405) auf der dielektrischen Schicht (203, 403) ein Schritt des hydrophilen molekularen Bondens ist, und wobei die erste Vertiefung (209, 211) zum Entgasen von Wasserstoff während des Schritts des Aufwachsens des Mehrfach-Quantentopfs auf der III-V-Materialschicht (207, 405) ausgestaltet ist.

13. Vorrichtung, die kombiniertes Silicium-"Si"-Material und III-V-Material aufweist, umfassend:
- ein Si-Substrat (201, 401),
- eine Grenzflächenschicht (203, 403) auf dem Si-Substrat (201, 401),
- eine III-V-Materialschicht (207, 405) auf der Grenzflächenschicht (203, 403),
- eine erste Vertiefung (209, 211), die sich in der III-V-Materialschicht (207, 405) und in der Grenzflächenschicht (203, 403) erstreckt,
- wobei die erste Vertiefung (209, 211) zum Unterdrücken einer Erzeugung einer Anomalie (413) während des Erhitzens der III-V-Materialschicht (207, 405) ausgestaltet ist, wobei die Grenzflächenschicht (203, 403) eine dielektrische Schicht (203, 403) ist und wobei die Anomalie (413) ein Loch ist.

14. Vorrichtung, die kombiniertes Silicium-"Si"-Material und III-V-Material nach Anspruch 13 aufweist, wobei die III-V-Materialschicht (207, 405) eine InP-Schicht ist.

15. Vorrichtung, die kombiniertes Silicium-"Si"-Material und III-V-Material aufweist, nach Anspruch 13 oder Anspruch 14, ferner umfassend:
- einen Wellenleiter (205) in der Grenzflächenschicht (203), und
- einen Mehrfach-Quantentopf auf der Grenzflächenschicht (203, 403), wobei der Mehrfach-Quantentopf dazu ausgestaltet ist, mit dem Wellenleiter (205) gekoppelt zu werden,
- wobei die erste Vertiefung (209, 211) sich in dem Mehrfach-Quantentopf erstreckt,
- die erste Vertiefung (209, 211) zum Steuern des Wachstums des Mehrfach-Quantentopfs auf der III-V-Materialschicht (207, 405) ausgestaltet ist.

## Revendications

1. Procédé pour combiner un matériau en silicium "Si" et un matériau III-V, comprenant les étapes suivantes :
- superposition d'un substrat de Si (201, 401) avec une couche d'interface (203, 403),
- superposition d'une couche de matériau III-V (207, 405) sur la couche d'interface (203, 403),
- formation d'un premier évidement (209, 211) s'étendant dans la couche de matériau III-V (207, 405) et dans la couche d'interface (203, 403),
dans lequel la couche d'interface (203, 403) est une couche diélectrique (203, 403), et
dans lequel le premier évidement (209, 211) est configuré pour supprimer la génération d'une anomalie (413) dans la couche de matériau III-V (207, 405) pendant une étape de chauffage de la couche de matériau (207, 405), l'anomalie (413) étant un trou.

2. Procédé pour combiner un matériau en silicium Si et un matériau III-V selon la revendication 1, dans lequel l'étape de superposition de la couche de matériau III-V (207, 405) sur la couche d'interface (203, 403) est une étape de collage de la couche de matériau III-V (207, 405) sur la couche d'interface (203, 403) par liaison moléculaire.

3. Procédé pour combiner un matériau en silicium Si et un matériau III-V selon la revendication 1 ou la revendication 2, comprenant en outre une étape de chauffage de la couche de matériau III-V (207, 405) sur la couche d'interface (203, 403).

4. Procédé pour combiner un matériau en silicium Si et un matériau III-V selon la revendication 2, dans lequel l'étape de collage de la couche de matériau III-V (207, 405) sur la couche diélectrique (203, 403) est une étape de liaison moléculaire hydrophile, et comprenant en outre une étape de chauffage de la couche de matériau III-V (207, 405) sur ladite couche diélectrique (203, 403), et dans lequel le premier évidement (209, 211) est configuré pour dégazer de l'hydrogène.

5. Procédé pour combiner un matériau en silicium Si et un matériau III-V selon l'une quelconque des revendications 1 à 4, dans lequel le premier évidement a une largeur (T_W) sur la couche de matériau III-V (207, 405) située dans la plage allant de 1 µm à 50 µm, de préférence de 10 µm.

6. Procédé pour combiner un matériau en silicium Si et un matériau III-V selon l'une quelconque des revendications 1 à 5, comprenant en outre une étape de formation d'un deuxième évidement (211) s'étendant dans la couche de matériau III-V (207, 405) et la couche d'interface (203, 403), dans lequel la distance (T_D) sur la couche de matériau III-V (207, 405) entre le premier évidement (209) et le deuxième évidement (211) est située dans la plage comprise entre 1 µm et 100 µm.

7. Procédé pour combiner un matériau en silicium Si et un matériau III-V selon l'une quelconque des revendications 1 à 6, dans lequel la couche de matériau III-V (207, 405) est une couche de phosphure d'indium (207, 405).

8. Procédé pour combiner un matériau en silicium Si et un matériau III-V selon l'une quelconque des revendications 1 à 7, comprenant en outre une étape de
- croissance d'un puits quantique multiple sur la couche de matériau III-V (207, 405),
- dans lequel le premier évidement (209, 211) est configuré pour supprimer l'anomalie (413) dans la couche de matériau III-V (207, 405) pendant l'étape de croissance du puits quantique multiple,
- dans lequel le premier évidement (209, 211) est configuré pour contrôler la croissance du puits quantique multiple sur la couche de matériau III-V (207, 405).

9. Procédé pour combiner un matériau en silicium Si et un matériau III-V selon la revendication 8, dans lequel l'étape de croissance du puits quantique multiple sur la couche de matériau III-V (207, 405) est une étape de croissance par épitaxie en phase vapeur aux organométalliques du puits quantique multiple.

10. Procédé pour combiner un matériau en silicium Si et un matériau III-V selon la revendication 8 ou la revendication 9, dans lequel le premier évidement (209, 211) est configuré pour contrôler la croissance du puits quantique multiple sur la couche de matériau III-V (207, 405) en agissant comme un masque de croissance et en évitant une prolifération latérale du puits quantique multiple.

11. Procédé pour combiner un matériau en silicium Si et un matériau III-V selon la revendication 8 ou la revendication 9, dans lequel le premier évidement (209, 211) est configuré pour contrôler la croissance du puits quantique multiple sur la couche de matériau III-V (207, 405) en agissant comme un masque de croissance de zone sélective.

12. Procédé pour combiner un matériau en silicium Si et un matériau III-V selon l'une quelconque des revendications 8 à 11, dans lequel l'étape de collage de la couche de matériau III-V (207, 405) sur la couche diélectrique (203, 403) est une étape de liaison moléculaire hydrophile, et dans lequel le premier évidement (209, 211) est configuré pour dégazer de l'hydrogène pendant l'étape de croissance du puits quantique multiple sur la couche de matériau III-V (207, 405).

13. Dispositif ayant un matériau en silicium "Si" et un matériau III-V combinés, comprenant :
- un substrat de Si (201, 401),
- une couche d'interface (203, 403) sur le substrat de Si (201, 401),
- une couche de matériau III-V (207, 405) sur la couche d'interface (203, 403),
- un premier évidement (209, 211) s'étendant dans la couche de matériau III-V (207, 405) et dans la couche d'interface (203, 403),
- ledit premier évidement (209, 211) étant configuré pour supprimer la génération d'une anomalie (413) pendant le chauffage de la couche de matériau III-V (207, 405),
dans lequel la couche d'interface (203, 403) est une couche diélectrique (203, 403), et dans lequel l'anomalie (413) est un trou.

14. Dispositif ayant un matériau en silicium "Si" et un matériau III-V combinés selon la revendication 13, dans lequel la couche de matériau III-V (207, 405) est une couche d'InP.

15. Dispositif ayant un matériau en silicium "Si" et un matériau III-V combinés selon la revendication 13 ou la revendication 14, comprenant en outre :
- un guide d'onde (205) dans la couche d'interface (203), et
- un puits quantique multiple sur la couche d'interface (203, 403), ledit puits quantique multiple étant configuré pour être couplé au guide d'onde (205),
- ledit premier évidement (209, 211) s'étendant dans le puits quantique multiple,
- ledit premier évidement (209, 211) étant configuré pour contrôler la croissance du puits quantique multiple sur la couche de matériau III-V (207, 405).
